# EUROPEAN PATENT APPLICATION

(11) **EP 1 220 592 A1**
(43) Date of publication of application: **03.07.2002**
(21) Application number: 00610144.8
(22) Date of filing: 28.12.2000
(51) Int. Cl.: H05K 7/14, F16B 21/04, H05K 3/36

(54) **An apparatus and a method of providing a flexible electrical connection between two components**

(71) Applicant: TELEFONAKTIEBOLAGET L M ERICSSON (publ), 126 25 Stockholm (SE)
(72) Inventor: Isacsson, Kent, 692 34 Kumla (SE)
(74) Representative: Wittrup, Flemming

(57) **Abstract**

A connecting means (10) adapted to be mounted through aligned openings in at least two components is provided, the connecting means comprising a pillar member (12) adapted to be mounted through an opening in a component and defining an axial direction of the connecting means, the pillar member comprising proximal and distal ends defining proximal and distal directions, spring means (15) arranged to exert a compression force substantially in the axial direction, first means (13) associated with the proximal end for supporting the spring means in the axial direction, and second means (17) associated with the distal end for mounting and securing the connecting means. By providing such a connecting means two components (50, 60) having openings and conducting surfaces in register with each other can be securely assembled and the conducting surfaces held properly in contact with each other.

## Description

### Technical field

The invention generally relates to an apparatus and a method of mechanically connecting and holding a first component, such as an electrical component, to a second component (also referred to as a substrate), such as a PCB (printed circuit board). More particularly, the present invention relates to a connector and a method of mechanically connecting an electrical connector to a PCB to provide electrical contact therebetween.

### Related prior art

It is well known to couple electrical components to conductive traces formed on PCBs. Such electrical components may be mechanically connected to the PCB, generally by fasteners, such as mounting posts, hold-downs, board locks, etc., that are inserted into corresponding openings formed in the PCB. These fasteners are typically used to align and secure the electrical component in a predetermined position.

Known fasteners for holding electrical components against the surface of a PCB include top-actuated eyelets, heat stakes, screws, rivets, non-metallic posts, plastics snap fit pegs, pinch eyelets, nuts and bolts, screws, and barbed press-fit hold-downs for securing the component to the PCB. Such fasteners typically extend through or engage a hole formed in the PCB.

The snap fit fasteners are also extensively used for the general purpose of holding parts together, for example when panels are fitted in automobiles, see for example DE-A-1 195 43 830.

The conventional fasteners, however, typically exhibit a high insertion force in order to insert the fastener into the opening in the PCB, making mounting of the electrical component onto the surface of the PCB difficult. In addition, many of the conventional fasteners exhibit a low retention force between the fastener and the side walls of the opening in the PCB, which results in the electrical component becoming loosened or dislodged from the surface of the PCB. Another type of fasteners is press fit into a hole in the board and held in place by elastic forces exerted on the side walls of the hole.

As mentioned above, the components can be secured by threaded means such as a screw mounted through aligned openings in the component and the PCB and attached to an underlying component such as a socket of a housing part. Although the screw may provide a high initial holding force, it is not a very reliable solution when relaxation of the screw takes place, for example when it is mounted into a socket of a plastics material. Further, in case the component to be mounted is a delicate structure, such as a thin, flexible sheet-like member, it is necessary to use a washer between the screw head and the sheet-like member in order to protect against the torsional forces exerted by the screw during mounting. As the washer may be very small, mounting thereof is difficult due to the small tolerances, requiring a complicated vision system to control correct placement during automatic assembly, which adds costs and complexity to the fastener and the assembly process.

Also, the mounting of the screw itself is time-consuming and thus cost in-effective. An example of such a sheet-like member is an illumination panel, also called an e-lamp, mounted with a conductive surface in contact with a PCB for a mobile phone, the e-lamp providing illumination of, for example, the keys of the phone.

### Objects of the invention

Accordingly, there remains a need for a fastening means and a method having the characteristics of simple mounting, preferably with a low insertion force, and at the same time a sufficient retention force to hold down various components to a substrate during an extended period of time. Further, it is an object of the invention to provide a fastening means and a method which ensure a well defined clamping force.

### Summary of the invention

The present invention is thus directed to an apparatus and a method of providing a simple yet reliable means for connecting an electrical device to a substrate, such as a PCB.

The present invention is based on the realization that the compression force necessary to achieve a reliable connection between the two elements, i.e. the electrical component and the substrate, should be provided by a "specialized" spring member held in place such that it exerts a compression force onto the two elements, thereby establishing the desired electrical contact. In this way the holding and compression means can be split and thus optimised for any specific needs related to the actual components to be mounted.

The principle of establishing an electrical contact based on a spring element is well known as such, for example in a torch where the batteries are held in contact with each other by a helical spring mounted in the end cap, or in a mobile phone wherein a SIM card or a battery pack is held in place against spring-like contact members. However, in these applications the spring member is a functional, electrical component itself, in contrast to the present invention which has as its object to provide contact between components which does not possess spring-like characteristics in the general direction of the compression force.

According to one aspect of the present invention a connecting means is provided adapted to be mounted through aligned openings in at least two components, the connecting means comprising a portion adapted to be mounted through the openings and defining an axial direction of the connecting means, and spring means arranged to exert a compression force substantially in the defined axial direction, the spring means providing a compression force between the at least two components in its mounted position. In the context of the present application, the term "opening" defines closed structures such as a hole or a slot as well as open structures such as a slot extending to a free edge. All of these structures may be through going or be closed at an end thereof.

By using a connecting means mounted through aligned openings, the components can be fixed against movement relative to each other.

In a preferred embodiment the connecting means is a separate connecting element for connecting and holding the at least two components in contact with each other, allowing for easy handling of the assembled components, however, the connecting means may also be formed integrally with other components, for example a frame or housing component of an electronic device such as a mobile phone.

In a further preferred embodiment the portion adapted to be mounted through the openings is a pillar member comprising first and second ends, a support means arranged corresponding to the first end and a gripping means arranged corresponding to the second end, the gripping means adapted to grip and secure the connecting element relative to the at least two components, and the support means adapted to support the spring means, allowing the spring means to exert a compression force between the at least two components in their mounted position. The gripping means may be adapted to engage one of the components to be mounted, for example an engagement surface portion thereof, or it may be adapted to engage a supporting structure, for example a frame or housing component.

When the gripping means is adapted to engage one of the components to be mounted, it may be in the form of snap-lock detents providing ease of mounting, however, it may also be in the form of flange members adapted to be rotated into engagement, such an arrangement providing ease of disassembling. For a preferred snap-lock arrangement, a removal tool is also provided. A further advantage of a snap-lock arrangement is that flexing snap-lock detents allow spring means and further components with a through hole to be easily mounted on the pillar portion.

The spring means may be in the form of one or more spring members formed by any suitable material and in any suitable configuration provided they exert the specified compression over a specified period of time, the latter normally only being an issue with polymeric materials, in contrast to metals. The spring means may be arranged to exert the compression force evenly over a given surface area or punctually at a number of locations. In case the "inherent" characteristics of the spring means provide a punctual compression force, an element such as a washer may be arranged between the spring means and the surface of the component upon which the spring means acts in order to either protect the surface, for example when formed of a thin sheet-like material, or when an evenly distributed compression force is desirable. Indeed, an additional element adds to the bulk, complexity and costs of the connecting means.

Examples of suitable spring means would be helical coils, leaf springs or wave-formed washers, preferably in metal, or "block-like" springs, basically formed of a polymeric material.

In a further embodiment of the invention, an assembly is provided comprising a component having a conducting surface, a connecting means mounted through an opening in the component, the connecting means comprising a portion adapted to be mounted through the opening and defining an axial direction of the connecting means, gripping means securing the connecting means relative to the component and spring means arranged to exert a compression force substantially in the defined axial direction, the spring means providing a compression towards the component, the gripping means being adapted to grip a further component having a conducting surface, the spring means providing a compression force between the two components, thereby forcing the conducting surfaces into contact with each other.

In a further preferred embodiment of the invention, an assembly is provided comprising at least two components having openings in register with each other and conducting surfaces in mutual contact, a connecting means comprising a portion mounted through the openings and defining an axial direction of the connecting means, and spring means arranged to exert a compression force substantially in the defined axial direction, the spring means providing a compression force between the at least two components, thereby forcing the conducting surfaces into contact with each other.

In further preferred embodiments of the assemblies, the connecting means is formed in accordance with the description given above for the connecting means itself.

In a further aspect of the invention an assembly is provided comprising at least two components having conducting surfaces in mutual contact with each other, a connecting means comprising a first support structure and a second supporting structure, a spring means exerting a compression force onto the at least two components in a direction substantially perpendicular to the conducting surfaces, thereby holding the conducting surfaces in contact with each other, the at least two components and the spring means being held in engagement between the first and second support structures. By this arrangement it is not necessary to provide openings in the components to be connected.

From the prior art it is well known to clamp conductive components together between rigid members, and although the term "rigid" is not an absolute term (i.e. every element is elastic to a certain degree) it is considered that to the skilled person the term "spring means" properly distinguishes the present invention over such "rigid members".

It should be emphasised that the term "comprise/comprising" when used in this specification is taken to specify the presence of stated features, integers, steps or components, but does not preclude the presence or addition of one or more other features, integers, steps components or groups thereof.

### Description of the drawings

The invention will be described in detail in the following with reference to the drawings, in which
figs. 1A and 1B show a first embodiment of a fastener according to the invention,
figs. 2A and B show a second embodiment of a fastener according to the invention,
figs. 3 shows a further embodiment of a fastener according to the invention,
figs. 4A and 4B show first and second components assembled using a fastener as shown in fig. 1A,
fig. 5A shows a further embodiment of a fastener according to the invention,
figs. 5B and 5C show a component in which a fastener as shown in fig. 5A is mounted,
figs. 6A and 6B show a removal tool in combination with a fastener as shown in fig. 1A,
fig. 7A shows an embodiment of the invention with a gripping means formed as a separate member,
fig. 7B shows an embodiment of the invention in which a gripping means is formed integrally with a structural component,
fig. 7C shows an embodiment of the invention in which both a pillar member and a gripping means are formed integrally with structural components, and
fig. 7D shows an embodiment of the invention in which first and second support means are formed integrally with structural components.

### Detailed description of preferred embodiments of the invention

In the description of the various embodiments the terms "upper" and "lower" as well as "proximal" and "distal" are used, however, these terms merely refer to the orientation of the various elements in the drawings and/or during traditional mounting procedures. Indeed, the described orientations are not intended to define any preferred orientation of any given member, but are merely used as a conventional and convenient way of defining opposed directions.

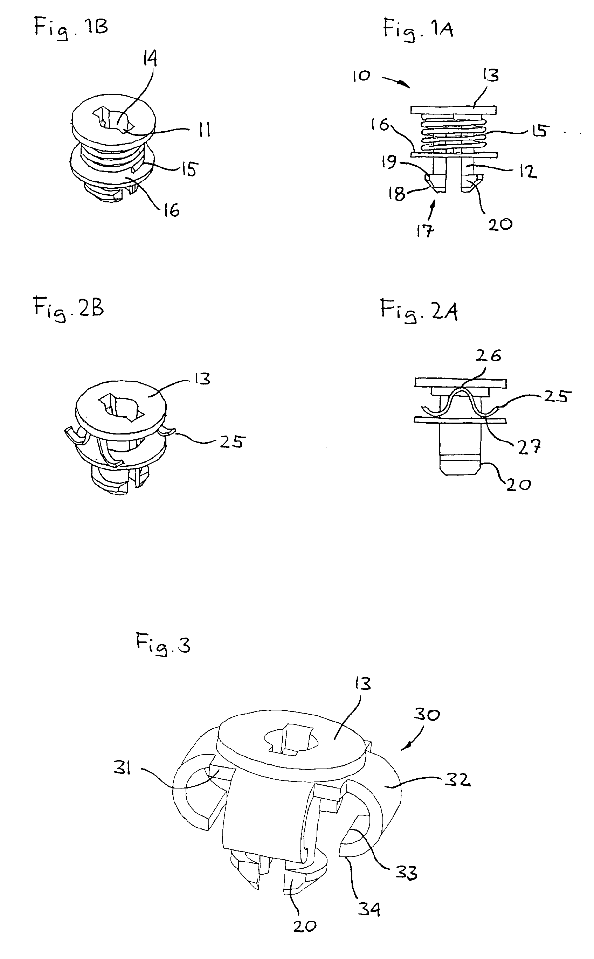

Figs. 1A and 1B show a first embodiment of a connecting means according to the invention in the form of a fastener.

The fastener comprises a base member, a spring member and a washer. The base member comprises a pillar member which, in the shown embodiment, includes two co-axially arranged leg members 12 mounted with a spacing therebetween, having a first upper end and a second lower end, the pillar member defining a general longitudinal axis of the fastener. The leg members each make up a longitudinal segment of a tube, thus forming a pillar member with an axial bore having peripherally arranged longitudinal slots. Preferably the pillar member has a circular cross-section. At their first end the leg members are connected to a support member 13 and at their second free end each leg comprises a gripping element 17 in the form of a detent. The support member, the leg members and the gripping elements are preferably formed integrally and of a flexible plastics material allowing the free second end of the leg members to flex or bend in a direction perpendicular to the longitudinal axis. The gripping elements are formed as hook-like members each having a lower chamfered surface 18 facing outwardly and downwardly as well as an upper substantially planar surface perpendicular to the longitudinal axis. In the shown embodiment each of the two chamfered surfaces makes up a portion of a circular cone segment. In this way the gripping elements form a pointed lower end of the fastening element having an initial width in the bending direction with the leg members arranged in parallel and a more narrow width in the bending direction when the gripping elements and the legs are bent or compressed towards each other, allowing the gripping means to provide a snap-lock action when advanced through an opening having a width smaller than the initial width of the gripping means and larger than the width of the compressed leg members. In order to allow the gripping means to be advanced through a circular opening the side surfaces 20 of the gripping elements are cut off corresponding to planes in parallel with the plane in which the leg members bend. As will appear from the figures, the width of the gripping means in a direction perpendicular to the plane in which the leg members bend corresponds to the "diameter" of the combined leg members.

The support member is in the form of a disk-like member 13 with an upper and a lower surface as well as an opening 14 communicating with the axial bore of the column member. The peripheral slots formed between the leg members extend through the disk member forming corresponding slots 11 in the opening 14. Mounted on the pillar member is a spring member in the form of a helical coil 15 having upper and lower ends as well as a ring-formed washer 16 having upper and lower surfaces. Both the coil and the washer are arranged axially displaceable on the pillar member. In the situation shown in figs. 1A and 1B the upper end of the coil is in contact with the lower surface of the support disk 13 and the lower end of the coil is in contact with the upper surface of the washer.

Figs. 2A and 2B show a fastener with a base member and a washer substantially as described above with respect to figs. 2A and 2B, however the helical coil has been replaced with two wave-formed leaf springs 25 each having a top portion 26 and two feet portions 27. The leaf springs are attached to either the washer or the disk member. The springs may be attached to the support by heat-staking (i.e. a protrusion on the support is advanced through an opening in the spring and subsequently heat-formed to lock the spring in place, this not shown), or they may be attached to the washer by spot-welding corresponding to one foot portion only, allowing the other foot to slide on the washer.

Also fig. 3 shows a fastener with a base member substantially as described above with respect to figs. 2A and 2B, however the washer has been left out and the helical coil has been replaced with an integrated spring member comprising a base portion 31 with a central opening arranged axially displaceable on the pillar member. The base portion carries four leaf springs 32 arranged as two pairs on opposite sides of the base portion. Each leaf spring is formed as a semi-circular segment with a first end attached to the base portion and a second free end 33 with a downwardly facing surface 34, the springs being arranged to be compressible in the axial direction of the fastener.

In the figs. 1-3 embodiments the spring member is supported by a separate upper support member 13, however, the spring member may also be attached directly corresponding to an upper end of the pillar member. Therefore, in the context of the present application, the term support member for the spring merely indicates that the spring is held in place when compressed.

The purpose of the washer is to distribute the downwardly directed force of the spring member over a given area in order to avoid high local compression forces, however, in case the contact surface of the spring member itself is sufficiently large, the washer can be dispensed with as illustrated in fig. 3. In the fig. 1 embodiment the helical coil may be formed with a lower turn substantially in a plane perpendicular to the axis of the coil, whereby the force may be evenly distributed without the need for a washer, such a washer adding to the complexity, bulk and costs of the fastener.

As described in the introductory portion, an object of the invention is to establish a compression force between two conducting surfaces in mutual contact with each other and arranged on respective components. The fasteners described with respect to figs. 1 to 3 are adapted to be used in situations where the conducting surfaces are arranged in the vicinity of openings in relatively thin board- or sheet-like members.

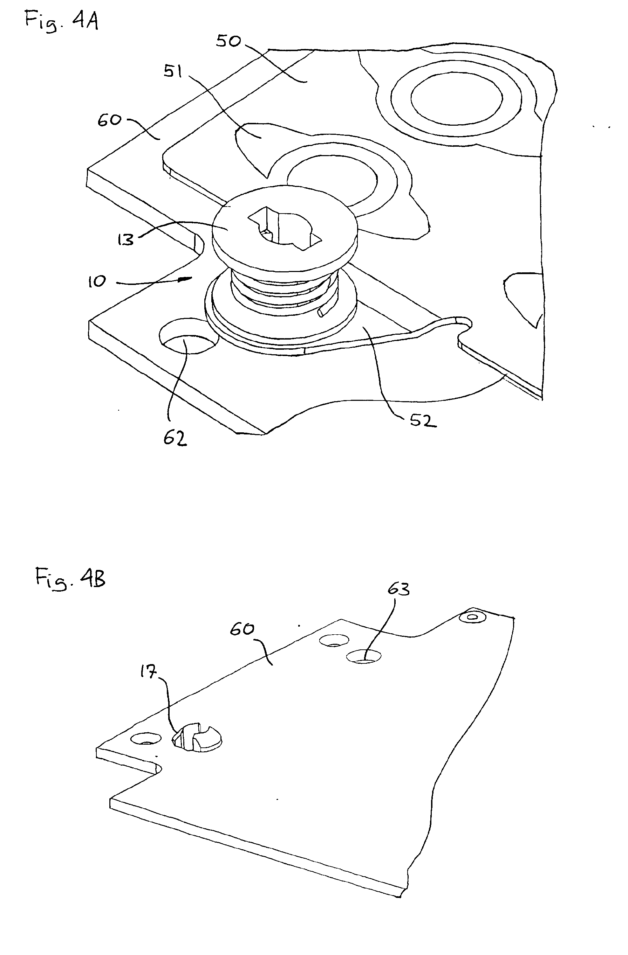

Fig. 4 illustrates an assembly for a mobile phone comprising a sheet member 50 and a PCB 60, each having an upper and a lower surface. The sheet member may be a so-called e-lamp comprising a number of contact and spring members 51 arranged with respect to corresponding contacts (not shown) on an upper surface of the PCB, however, these contacts are not part of the present invention and will not be described in greater detail. The sheet member 50 comprises an extension 52 with a first circular opening arranged in register with a corresponding second opening in the PCB (in the drawing the openings cannot be seen). A first conducting area on the lower surface of the sheet member 50 is arranged circumferentially with respect to the first opening, and a second conducting area on the upper surface of the PCB 60 is arranged circumferentially with respect to the second opening. Preferably the two openings have a diameter corresponding substantially to the diameter of the pillar member of the fastener. The PCB also has other openings 62, 63 to be used for other purposes such as alignment or securing to a frame or housing.

When the two openings are aligned, the pointed gripping means are placed in the opening and an axial force is applied to the upper surface of the support member 13. Due to the chamfered lower surface 17 of the gripping means, the gripping means and the leg members are flexed towards each other, allowing the bent-together gripping means to be advanced through the aligned openings after which they expand outwardly again in a snap action, the upper surface 19 of the gripping means preventing the fastener from being pulled out again.

It is clear that the snap-lock gripping means also allows easy mounting of the spring and any washer during manufacture of the fastener.

As the fastener is advanced, the coil (or any corresponding spring member) is compressed between the upper surface of the sheet member and the support disk, or more correctly, between the upper surface of the washer and the support disk, the washer transmitting and distributing the compression force from the coil spring. Indeed, the distance between the lower end of the coil or washer and the upper surface 19 of the gripping members shall be less than the combined thickness of the boards or sheets to be mounted therebetween. Most types of springs, such as a coil spring, can be designed to provide a substantially constant force within a given range of compression, allowing the fastener to be used with components having different thickness but still providing a predetermined compression force.

Fig. 4A shows the situation when the fastener has been fully advanced through the openings and has locked the two members together. Fig. 4B shows the same situation from below where it appears that the gripping means has engaged the lower surface of the PCB. As also described in the introductory portion, the fastening means according to the invention may be used to provide contact between two or more members, which could mean in the above-described example that a further component is arranged below the PCB.

In the assembling procedure described with respect to figs. 4A and 4B, the fastener has been mounted on the two components after these have been positioned relative to each other, however, according to an aspect of the present invention, the upper component (here: the e-lamp sheet) can be supplied with the fastener mounted, allowing for easy click-on mounting of the upper component onto the lower component(s).

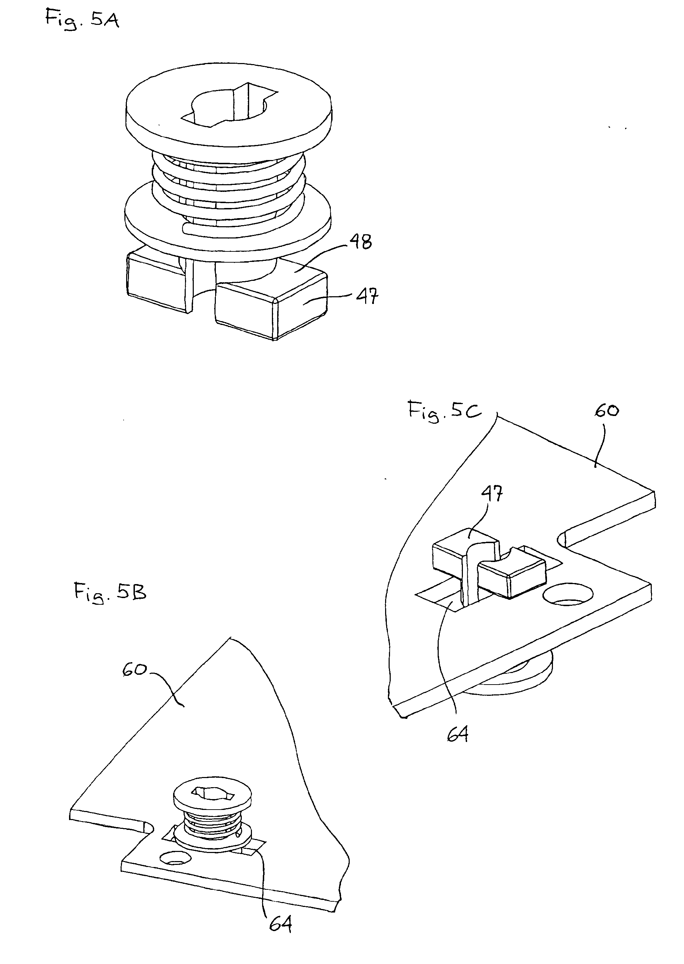

Next a further embodiment of the fastener will be described with respect to figs. 5A to 5C. Fig. 5A shows a fastener with a base member, a washer and a coil spring substantially as described above with respect to figs. 2A and 2B, however, each of the chamfered gripping means has been replaced with a foot-like extension protruding at a right angle from the leg member. Although the feet are mounted on a tube-formed pillar member having flexible leg members, this is not essential to this embodiment. The gripping means is adapted to be mounted through one or more slots each having a width corresponding to the width of the feet and a length at least corresponding to the combined length of the feet, this allowing the fastener to be placed through the opening(s) in the component(s) and subsequently rotated, preferably through 90 degrees, the upper surfaces 48 of the feet engaging the lower surface of a component, thereby locking the fastener in place. Although the rotational mounting procedure may be more time-consuming, it allows easy removal of the fastener during disassembling of the components.

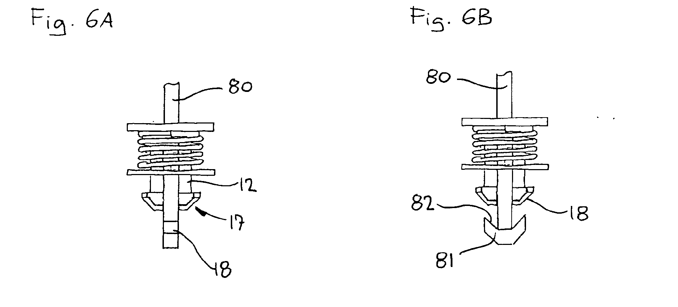

However, the present invention also provides a tool whereby the snap-on embodiments shown in figs. 1 to 4 can be removed. As can be seen in figs. 6A and 6B the tool comprises a post member 80 which, on its lower, end has an arrow-like head with two outwardly and upwardly directed fingers 81. The width of the fingers and the post, as seen in fig. 6A, allows the tool to be introduced through the central bore of the pillar member with the fingers 81 sliding in the slots between the leg members. Each finger has an upper surface 82 inclined corresponding to the lower chamfered surface 18 of the gripping members 17. When the tool has been advanced through the central bore, it is rotated 90 degrees to the position seen in fig. 6B after which it is pulled into contact with the gripping means of the fastener. As the inclined surfaces 82 are forced against the chamfered lower surfaces 18, the gripping means 17 and the legs 12 are forced inwardly, allowing the fastener to be pulled rearwardly through the opening in which it has been mounted (not shown). Indeed, the width of the central opening in the fastener, see fig. 1A, shall have a width allowing the legs to flex inwardly towards the post member 80.

Corresponding to the embodiments of the invention described with respect to figs. 1 to 6, "self-contained" fastening means has been described, however, components of the fastening means may be separated from the fastener "as such", or they may be integrated into other structural or functional components.

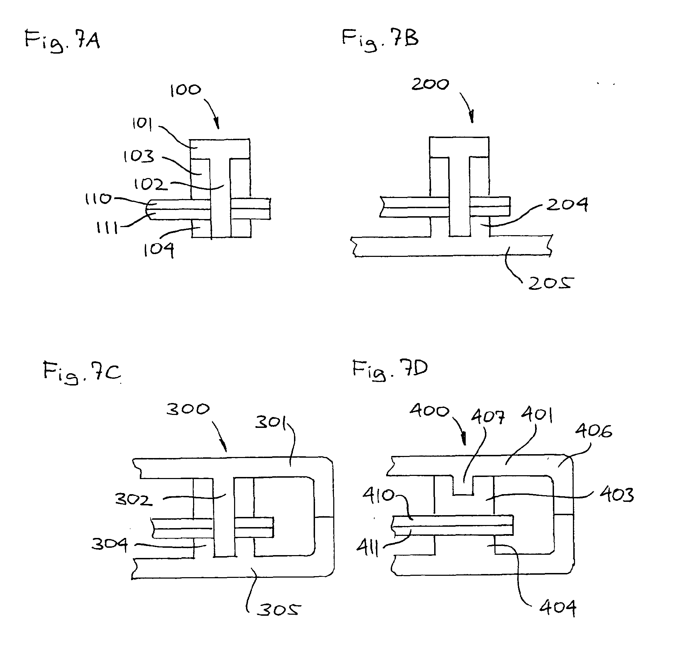

Fig. 7A shows a fastener 100 comprising a head or support 101 mounted on the proximal or upper end of a post or pillar member 101. The pillar is arranged through the aligned openings of first and second components 110, 111 and secured by a separate gripping means or member 104 mounted on the distal or lower end of the pillar. The gripping member can be attached to the pillar by any convenient means such as by gluing or welding or by a threaded or snap-lock engagement. Corresponding to the above-described embodiments a compressed spring member 103 is arranged and supported between the support member and an upper engagement surface of the components to be held together. The expression "engagement surface" merely defines that a given surface area is adapted to cooperate with the connecting means of the invention in any desirable way, e.g. by an applied compression force or by a gripping action.

In fig. 7B a fastener 200 is shown in which the gripping member 204 has been formed integrally with a structural component 205 such as a frame member or a housing portion. In the fig. 7C embodiment both the pillar member 302 and the gripping means 304 have been formed integrally with an additional structural component. As illustrated, the pillar has been formed integrally with an upper housing portion 301 and the gripping means 304 has been formed integrally with a lower housing portion 305. For the fastener 400 shown in fig. 7D the through-going pillar member as well as the openings in the components 410, 411 have been dispensed with, the fastener means merely serving as a clamping means holding the two components in contact with each other. The fastening means comprises a lower support structure 404 formed integrally with a lower housing or frame component and adapted to support a lower surface of the components 410, 411 as well as an upper support structure 401 formed integrally with an upper housing or frame component 406 and adapted to support the spring member against an upper surface of the components 410, 411 to be held together. In the shown embodiment the spring member 403 is located by a post 407, however, the spring member may be positioned and secured by any convenient means such as gluing, welding or heat-staking. Indeed, further means (not shown) may be necessary to properly locate and secure the components 410, 411 to be held together against movement in directions perpendicular to the compression force provided by the spring member.

In the shown embodiments two components are assembled in mating contact, however, it would be possible to hold together three or more components in a stacked alignment.

When in the context of the present invention it is defined that a support or gripping means engages a surface, this wording includes that such a surface is gripped or supported indirectly by said means, for example, a protecting washer may be placed between the upper surfaces of the support or gripping means, only the washer being in direct contact with a lower component such as a PCB. The indirect support may also be provided by a third component comprising a conducting surface which is brought into contact with a corresponding surface on a second component arranged between a first component and the third component.

## Claims

1. A connecting means (10, 100, 200, 300) adapted to be mounted through aligned openings in at least two components, comprising:
- a pillar member (12, 102, 302) adapted to be mounted through an opening in a component and defining an axial direction of the connecting means, the pillar member comprising proximal and distal ends defining proximal and distal directions,
- spring means (15, 25, 30, 103) arranged to exert a compression force substantially in the axial direction,
- first means (13, 101, 301) associated with the proximal end for supporting the spring means in the axial direction,
- second means (17, 104, 204, 304) associated with the distal end for mounting and securing the connecting means.

2. A connecting means as defined in claim 1, wherein the first means comprises a radially extending support member (11, 101) having a support surface facing in the distal direction, and wherein the second means comprises a radially extending support member (17, 104, 204, 304) having a support surface (19) facing in the proximal direction.

3. A connecting means as defined in claim 2, wherein at least one of the first and second means is formed integrally with a structural component, such as a frame or housing component, of an electronic device.

4. A fastener adapted to be mounted through aligned openings in at least two components, comprising:
- a pillar member (12) adapted to be mounted through an opening in a component and defining an axial direction of the fastener, the pillar member comprising proximal and distal end portions defining proximal and distal directions,
- support means (11) associated with the proximal end and having a first surface facing in the second direction,
- gripping means (17, 47) associated with the distal end and having a second surface (19, 48) facing in the second direction, and
- spring means (15, 25, 30) arranged to exert a compression force substantially in the distal direction when supported against the first surface.

5. A fastener as defined in claim 4, wherein the pillar member comprises at least one leg member (12) extending in the distal direction and having a gripping means (17) protruding in a radial direction, the leg member being flexible, allowing the gripping means to be moved in a direction generally perpendicular to the axial direction.

6. A fastener as defined in claim 4, wherein the pillar comprises at least two leg members (12) extending in the axial direction and each comprising a radially protruding gripping means (17) having a proximally directed surface (19), the leg members being separated from each other by longitudinal slots allowing the leg members and thereby the gripping means to be bent towards each other, the gripping means preferably being arranged at distal free ends of the leg members.

7. A fastener as defined in claim 6, wherein the gripping means comprises chamfered surfaces oriented radially-distally, the gripping means and the leg members thereby forming a snap-lock means when introduced through a corresponding opening in a component.

8. A fastener as defined in anyone of claims 1-7, wherein the spring means is chosen from the group comprising: at least one helical coil (15), a helical coil with a ring-formed washer member (16) associated with a distal end thereof, a leaf spring assembly (30) comprising at least one leaf spring (25, 32), a leaf spring assembly comprising a ring-formed washer member, and a foam member.

9. A fastener as defined in claim 7 or 8 in combination with a removal tool, wherein the support member (13) comprises an opening (14) in communication with a central bore of the pillar member, the removal tool comprising:
- a post member (80) comprising at least two radially extending projections (81) at a distal end thereof, each projection having a proximal surface (82) inclined inwardly corresponding to the lower chamfered surface (18) of the gripping members (17).

10. An assembly comprising a component (50) having an opening and a conducting surface area in the vicinity thereof, and a fastener as defined in anyone of claims 4-9 mounted through the opening.

11. An assembly comprising at least two components (50, 60, 110, 111) having openings in register with each other and conducting surfaces in mutual contact, and a connecting means or fastener as defined in anyone of claims 1-9 mounted through the openings, the spring means (15, 25, 30, 103) providing a compression force between the at least two components, thereby forcing the conducting surfaces into contact with each other, one of the components preferably being a PCB.

12. An assembly comprising at least two components (410, 411) having conducting surfaces in mutual contact, the assembly comprising an upper engagement surface and a lower engagement surface in register with each other, a lower support member adapted to support the lower engagement surface, a spring means (403), an upper support member (401) adapted to support the compressed spring means against the upper engagement surface, the spring means providing a compression force between the at least two components, thereby forcing the conducting surfaces into contact with each other.

13. An assembly as defined in claim 12, wherein the upper and lower support members are formed integrally with structural components, such as a frame or housing portion, of an electronic device.

14. An assembly as defined in anyone of claims 10-13, wherein the assembly is adapted for use in or constitutes a part of a mobile phone.

15. A method of assembling at least two components (50, 60, 410, 411) having conducting surfaces in mutual contact, comprising the steps of:
- providing a first component (60, 111, 411) having a first engagement surface and a first conducting surface area on an opposite side thereof and substantially in register therewith,
- providing a second component (50, 110, 410) having a second engagement surface and a second conducting surface area on an opposite side thereof and substantially in register therewith,
- placing the first and second conducting surface areas substantially in contact with each other,
- providing a first support means (17, 104, 303, 404) adapted to support the first engagement surface,
- providing a spring means (403),
- providing a second support means (13, 101, 301, 401) adapted to support the compressed spring means against the second engagement surface,
- arranging the first and second support means relative to each other such that the spring means provides a compression force between the two components, thereby forcing the conducting surfaces into contact with each other.

16. A method as defined in claim 15, wherein the first component comprises a first opening in the vicinity of the first conducting surface area and the second component comprises a second opening in the vicinity of the second conducting surface area, wherein the first and second support means are connected by a connecting means (12, 102) adapted to be mounted through the first and second openings in their aligned position, the method comprising the step of introducing the connecting means through the aligned openings.

17. A method as defined in claim 16, wherein the first support means is a snap-lock gripping means (17) engaging the first engagement surface when introduced through the openings in a direction from the second engagement surface.
